# EUROPEAN PATENT APPLICATION

(11) **EP 2 608 086 A2**
(43) Date of publication of application: **26.06.2013**
(21) Application number: 12188465.4
(22) Date of filing: 15.10.2012
(51) Int. Cl.: G06F 17/50, H02J 3/38, B60R 21/16

(54) **Systems and Methods of Designing Airbag**

(30) Priority: 21.12.2011 US 201113333087
(71) Applicant: Livermore Software Technology Corporation, Livermore CA 94551 (US)
(72) Inventor: Bhalsod, Dilip Mulji, Troy, MI 48098 (US)
(74) Representative: Becker Kurig Straus

(57) **Abstract**

Systems and methods for numerically creating corresponding 2-D mesh models for a plurality of airbag fabric panels from a 3-D computerized model of a fully-inflated airbag are disclosed. The 3-D computerized model comprises a plurality of nodes and a plurality of shell finite elements. Each shell element is categorized as to which one of a plurality of fabric panels that form the airbag it belongs. Each fabric panel occupies a continuous surface area of the airbag. Shell finite elements of a particular fabric panel are unfolded to a 2-D mesh one fabric panel at a time. The total surface area of a particular fabric panel is compared with the total area of the corresponding 2-D model. The 2-D mesh model is adjusted until the areas are within a predetermined tolerance. The final "total-area-matched" 2-D mesh model is further orientated to a fabric material coordinate system of warp and weft for determining manufacturability.

## Description

### FIELD OF THE INVENTION

The present invention generally relates to designing of an airbag, which is a vehicle safety device for increasing occupant safety during an automobile collision, more particularly to methods and systems for creating a plurality of two-dimensional mesh models (e.g., finite element analysis model) of fabric panels that form an airbag from a three-dimensional computerized model of the airbag in a fully-inflated configuration.

### BACKGROUND OF THE INVNETION

Airbag is made of a plurality of fabric panels stitched together and installed in an automobile to provide an occupant restraint in an automobile collision. Airbag contains a flexible envelope designed to inflate rapidly in a car crash, to prevent vehicle occupants from striking interior objects such as the steering wheel or a window. Modern vehicles may contain multiple airbags in various side and frontal locations of the passenger seating positions and sensors may deploy one or more airbags in an impact zone at variable rates based on the type and severity of impact.

With advent of computing technologies, airbag is designed using computer aided engineering analysis (e.g., a finite element analysis (FEA) collaborated between two groups of engineers/designers. The first group is responsible for protecting a vehicle occupant when airbag is fully-inflated in an automobile crash, while the second group for manufacturability of airbag. To satisfy these design goals, a three-dimensional fully-inflated geometry of an airbag is used by the first group while the two-dimensional flat geometry of the panels by the second group.

Since the design flow is from the first group to the second group, it would therefore be desirable to have methods and systems for numerically creating corresponding two-dimensional models of fabric panels from a three-dimensional computerized model of the airbag in a fully-inflated configuration.

### SUMMARY OF THE INVENTION

Systems, methods and software product for numerically creating corresponding two-dimensional (2-D) mesh models of a plurality of fabric panels that form an airbag from a three-dimensional (3-D) computerized model of a fully-inflated airbag are disclosed.

According to one exemplary embodiment of the present invention, a 3-D computerized model (e.g., finite element analysis model, grid model, etc.) of a fully-inflated airbag is defined. The 3-D computerized model comprises a plurality of nodes and a plurality of shell finite elements. Each shell element is designated to one of a plurality of fabric panels that form the airbag it belongs. Each fabric panel occupies a continuous surface area of the airbag. Shell finite elements of a particular fabric panel in respective three-dimensional topologies or geometries are unfolded to a two-dimensional mesh model one fabric panel at a time. The total surface area of a particular fabric panel is compared with the total area of the corresponding 2-D mesh model. Adjust the 2-D mesh model until the areas are within a predetermined tolerance. The final "total-area-matched" 2-D mesh model is further orientated to a fabric material coordinate system of warp and weft for determining manufacturability.

According to another aspect, the identifier for each shell element (e.g., element number, element label, etc.) is kept the same in the 3-D and 2-D models, while the identifiers for nodes (e.g., node number, node label, etc.) are different in two models.

According to yet another aspect, the area for airbag vents is included in the unfolding operation originally and then removed from the final 2-D mesh model, whose area matches the surface area of the 3-D model.

### BRIEF DESCRIPTION OF THE DRAWINGS

These and other features, aspects, and advantages of the present invention will be better understood with regard to the following description, appended claims, and accompanying drawings as follows:

FIG. 1 is a flowchart illustrating an exemplary process of creating 2-D mesh models of airbag fabric panels from a fully-inflated 3-D computerized model, according to an embodiment of the present invention

FIG. 2 is a perspective view showing a 3-D computerized model of the airbag in a fully-inflated configuration according to an embodiment of the present invention;

FIG. 3 is a diagram showing a scheme of unfolding a 3-D computerized model to a 2-D mesh model, according to an embodiment of the present invention;

FIGS. 4-5 shows a 2-D mesh models that are unfolded from the 3-D computerized model of FIG. 2

FIG. 6 is a diagram showing an exemplary warp and weft definitions to be used in a fabric material coordinate system, according to an embodiment of the present invention; and

FIG. 7 is a function diagram showing salient components of an exemplary computer, in which one embodiment of the present invention may be implemented.

### DETAILED DESCRIPTION

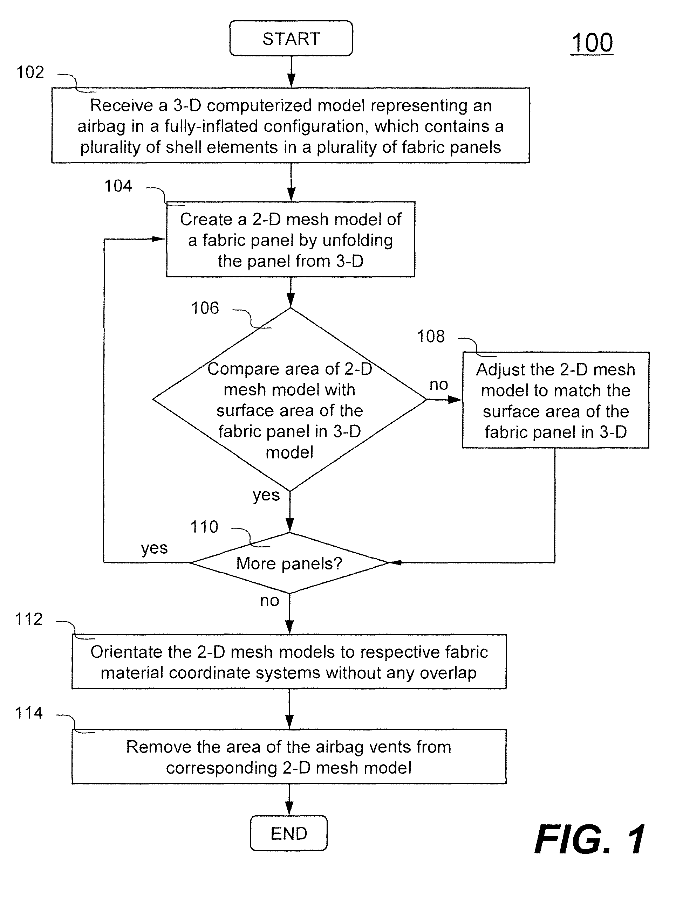

FIG. 1 is a flowchart illustrating an exemplary process 100 of designing an airbag used as a vehicle safety device for increasing occupant safety in an automobile collision, in particular, creating 2-D mesh models of fabric panels of an airbag from a 3-D computerized model of the airbag in fully-inflated configuration, according to an embodiment of the present invention. Process 100 is preferably understood in conjunction with the previous figures and is implemented in software.

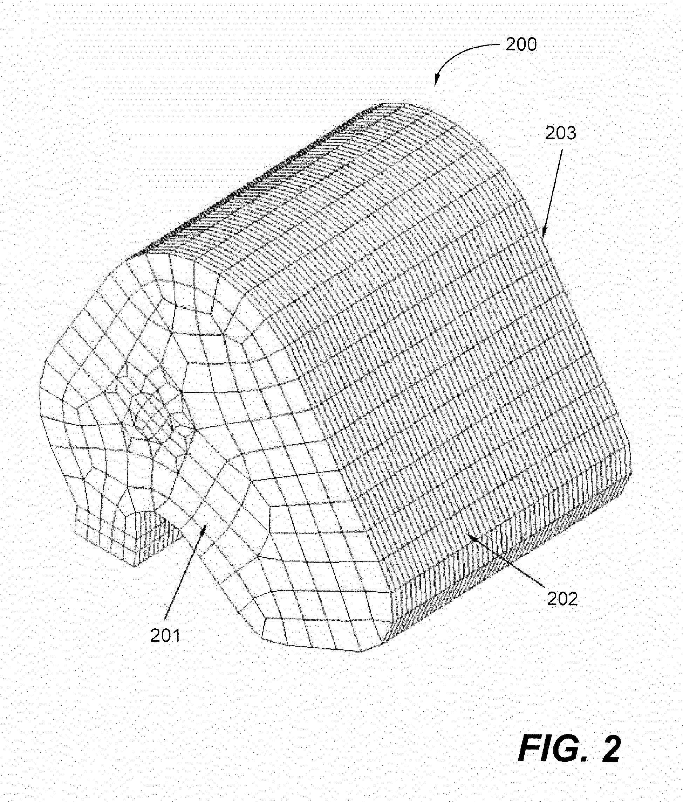

Process 100 starts by receiving a 3-D computerized model (e.g., finite element analysis model) of an airbag in a fully-inflated configuration at step 102. The 3-D computerized model comprises a plurality of nodes and a plurality of shell finite elements (e.g., quadrilateral element, triangular element, etc.). Since the airbag is made of a plurality of fabric panels, each shell finite element is further designated to one of the fabric panels. In other words, each fabric panel contains a portion of the shell elements of the 3-D computerized model. A perspective view of an exemplary 3-D computerized model 200 of an airbag in its fully-inflated configuration is shown in FIG. 2. Airbag 200 is made of three fabric panels 201, 202, 203 (the third panel 203 is hidden).

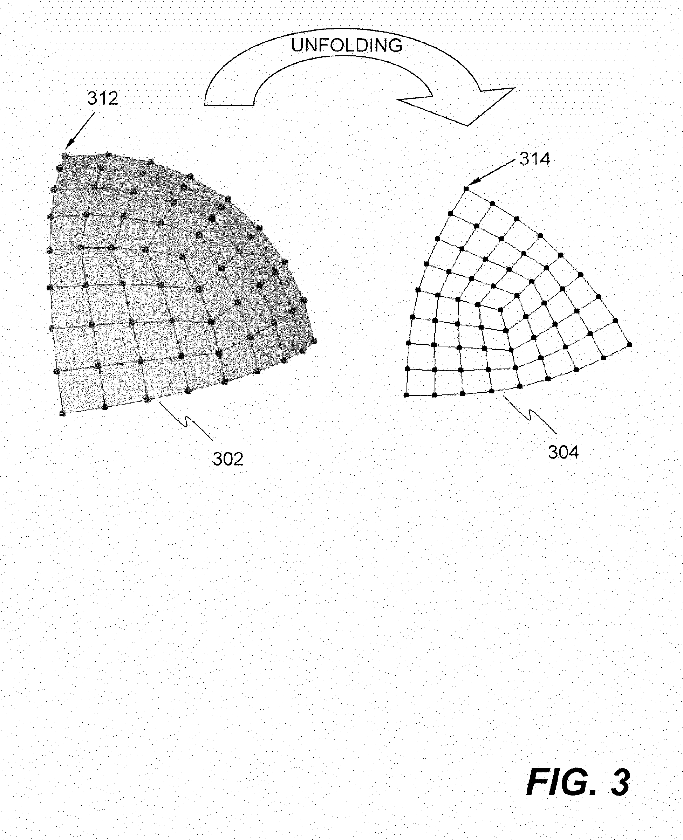

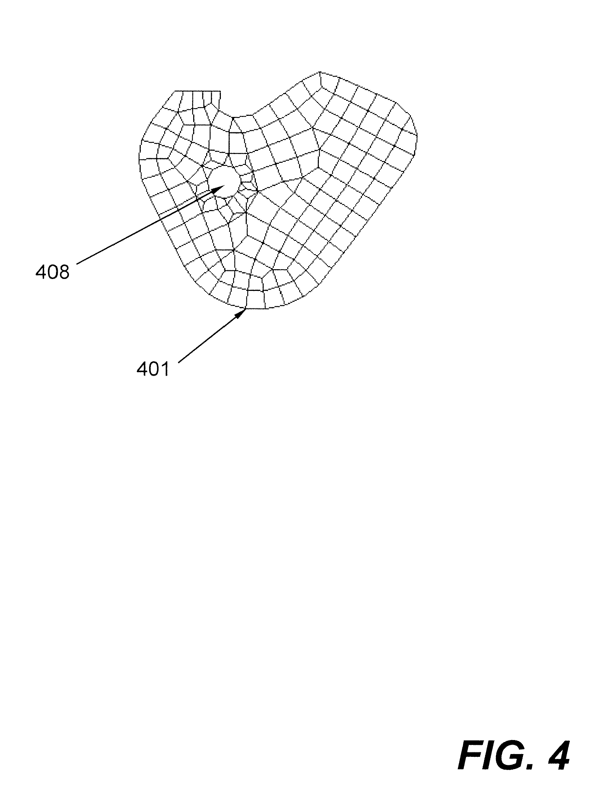

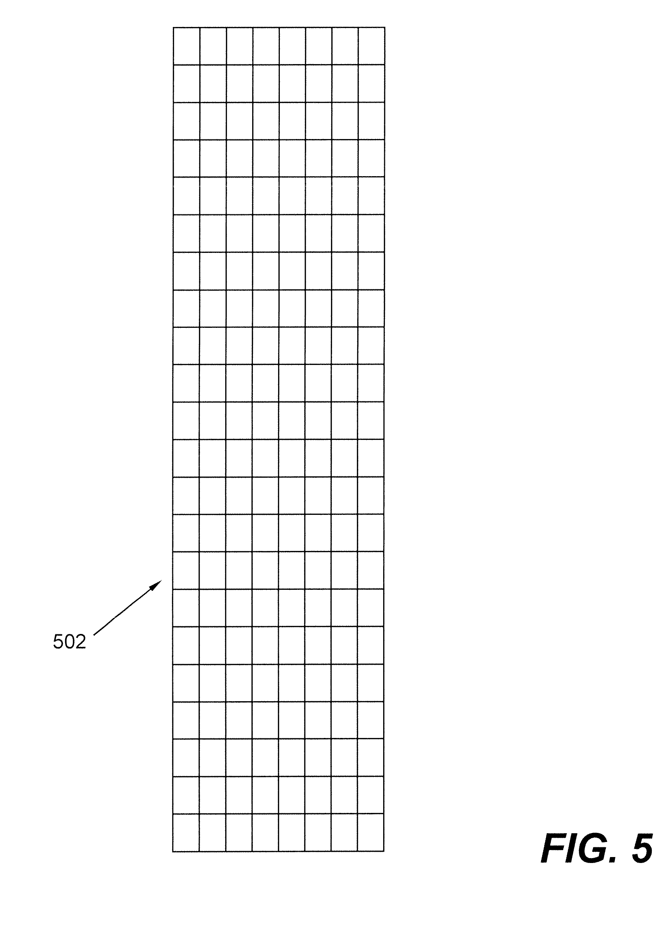

Next, at step 104, a 2-D mesh model is created for each fabric panel by unfolding those shell finite elements representing the particular fabric panel from a first orientation in the fully-inflated configuration to a second orientation of a flat geometry. The first orientation is defined by a set of node numbers in the 3-D computerized model, while the second orientation is defined by another set of node numbers of the 2-D mesh model. Element identifier (e.g., element number, element label) of each unfolded finite element is retained or remains to be the same. As an example of unfolding operation of a 3-D object to 2-D, FIG. 3 shows an exemplary 3-D computerized model 302 unfolded to a 2-D mesh model 304. The 3-D computerized model 302 represents a portion of curved dome structure defined by a set of nodes 312 having a first set of node numbers. The 2-D mesh model 304 represents the flattened 3-D computerized model 302 and defined by another set of nodes 314 having a second set of node numbers. 2-D mesh models 401 and 502 of the fabric panels 201 and 202 are shown in FIG. 4 and FIG. 5, respectively.

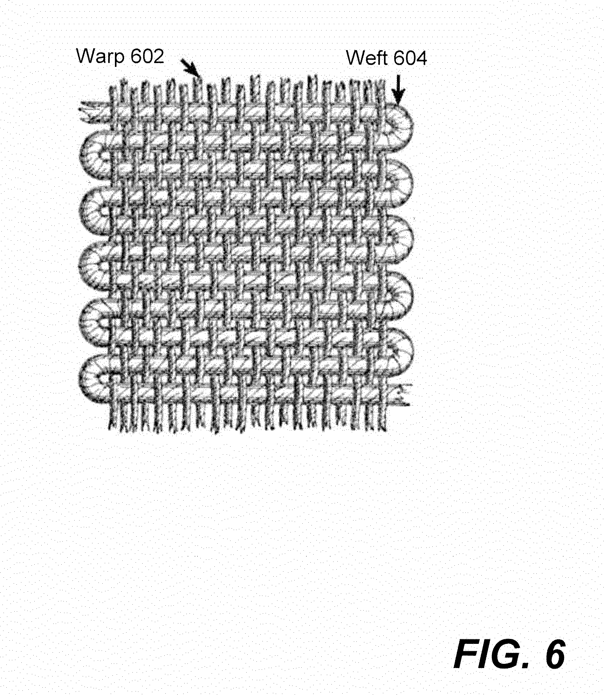

Process 100 moves then to decision 106, it is determined whether the total area of the 2-D mesh model is within a tolerance when comparing with the total surface area of those shell elements representing the particular fabric panel of the 3-D computerized model. The tolerance is established with known techniques, for example, a percentage of difference defined by user. If "no", process 100 moves to step 108, in which the 2-D mesh model is adjusted to match the total surface area. Next, at decision 110, if there are more panels in the airbag to be unfolded, process 100 moves back to step 104 to repeat the process for another fabric panel. Otherwise, process 100 moves to step 112, the 2-D mesh models are orientated to respective fabric material coordinate system of warp and weft for determining manufacturability. Finally, at step 114, the area 408 (FIG. 4) occupied by the airbag vents is removed from corresponding 2-D mesh model before process 100 ends. An exemplary warp 602 and weft 604 definition is shown in FIG. 6

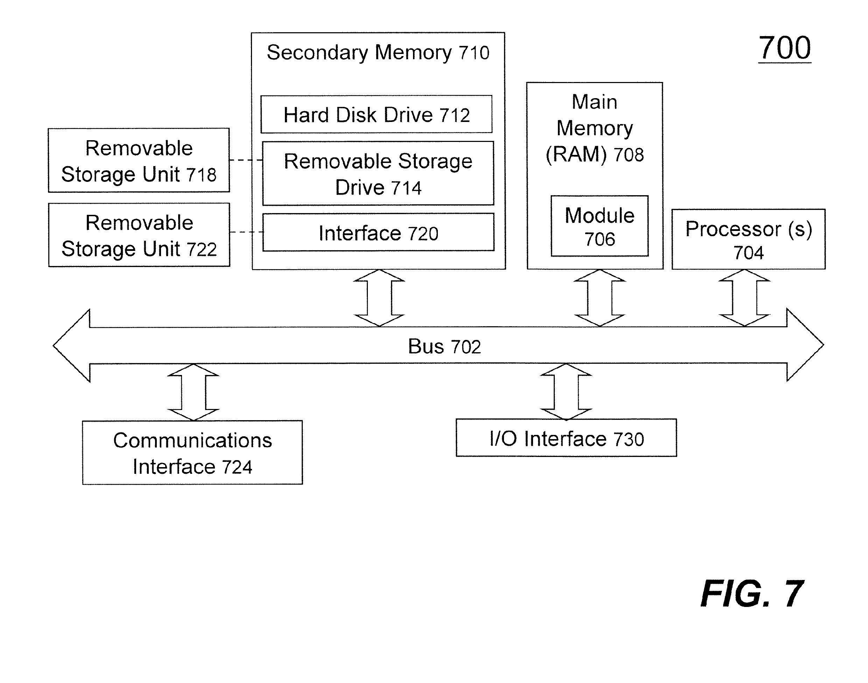

According to one aspect, the present invention is directed towards one or more computer systems capable of carrying out the functionality described herein. An example of a computer system 700 is shown in FIG. 7. The computer system 700 includes one or more processors, such as processor 704. The processor 704 is connected to a computer system internal communication bus 702. Various software embodiments are described in terms of this exemplary computer system. After reading this description, it will become apparent to a person skilled in the relevant art(s) how to implement the invention using other computer systems and/or computer architectures.

Computer system 700 also includes a main memory 708, preferably random access memory (RAM), and may also include a secondary memory 710. The secondary memory 710 may include, for example, one or more hard disk drives 712 and/or one or more removable storage drives 714, representing a floppy disk drive, a magnetic tape drive, an optical disk drive, etc. The removable storage drive 714 reads from and/or writes to a removable storage unit 718 in a well-known manner. Removable storage unit 718, represents a floppy disk, magnetic tape, optical disk, etc. which is read by and written to by removable storage drive 714. As will be appreciated, the removable storage unit 718 includes a computer usable storage medium having stored therein computer software and/or data.

In alternative embodiments, secondary memory 710 may include other similar means for allowing computer programs or other instructions to be loaded into computer system 700. Such means may include, for example, a removable storage unit 722 and an interface 720. Examples of such may include a program cartridge and cartridge interface (such as that found in video game devices), a removable memory chip (such as an Erasable Programmable Read-Only Memory (EPROM), Universal Serial Bus (USB) flash memory, or PROM) and associated socket, and other removable storage units 722 and interfaces 720 which allow software and data to be transferred from the removable storage unit 722 to computer system 700. In general, Computer system 700 is controlled and coordinated by operating system (OS) software, which performs tasks such as process scheduling, memory management, networking and I/O services.

There may also be a communications interface 724 connecting to the bus 702. Communications interface 724 allows software and data to be transferred between computer system 700 and external devices. Examples of communications interface 724 may include a modem, a network interface (such as an Ethernet card), a communications port, a Personal Computer Memory Card International Association (PCMCIA) slot and card, etc. The computer 700 communicates with other computing devices over a data network based on a special set of rules (i.e., a protocol). One of the common protocols is TCP/IP (Transmission Control Protocol/Internet Protocol) commonly used in the Internet. In general, the communication interface 724 manages the assembling of a data file into smaller packets that are transmitted over the data network or reassembles received packets into the original data file. In addition, the communication interface 724 handles the address part of each packet so that it gets to the right destination or intercepts packets destined for the computer 700. In this document, the terms "computer program medium" and "computer usable medium" are used to generally refer to media such as removable storage drive 714, and/or a hard disk installed in hard disk drive 712. These computer program products are means for providing software to computer system 700. The invention is directed to such computer program products.

The computer system 700 may also include an input/output (I/O) interface 730, which provides the computer system 700 to access monitor, keyboard, mouse, printer, scanner, plotter, and alike.

Computer programs (also called computer control logic) are stored as application modules 706 in main memory 708 and/or secondary memory 710. Computer programs may also be received via communications interface 724. Such computer programs, when executed, enable the computer system 700 to perform the features of the present invention as discussed herein. In particular, the computer programs, when executed, enable the processor 704 to perform features of the present invention. Accordingly, such computer programs represent controllers of the computer system 700.

In an embodiment where the invention is implemented using software, the software may be stored in a computer program product and loaded into computer system 700 using removable storage drive 714, hard drive 712, or communications interface 724. The application module 706, when executed by the processor 704, causes the processor 704 to perform the functions of the invention as described herein.

The main memory 708 may be loaded with one or more application modules 706 that can be executed by one or more processors 704 with or without a user input through the I/O interface 730 to achieve desired tasks. In operation, when at least one processor 704 executes one of the application modules 706, the results are computed and stored in the secondary memory 710 (i.e., hard disk drive 712). The status of the finite element analysis is reported to the user via the I/O interface 730 either in a text or in a graphical representation.

In one embodiment, an application module 706 is configured to facilitate the creation of the 2-D mesh models from a 3-D computerized model of a fully-inflated airbag. The application module 706 further allows the 2-D mesh models to be oriented with a fabric material coordinate system. In another embodiment, the application module 706 is configured to facilitate the removal of airbag vent area from the 2-D mesh models.

Although the present invention has been described with reference to specific embodiments thereof, these embodiments are merely illustrative, and not restrictive of, the present invention. Various modifications or changes to the specifically disclosed exemplary embodiments will be suggested to persons skilled in the art. For example, whereas a particular type of airbag has been shown and described for carrying out one embodiment of the present invention, other types of airbag may be used for accomplishing the same. Further, whereas three fabric panels have been shown and described to form an airbag, other number of panels can be used for accomplishing the same. Finally, 3-D computerized model and 2-D mesh model have been shown and described as examples, models with other mesh densities or shapes can be used for achieving objectives of the present invention. In summary, the scope of the invention should not be restricted to the specific exemplary embodiments disclosed herein, and all modifications that are readily suggested to those of ordinary skill in the art should be included within the spirit and purview of this application and scope of the appended claims.

## Claims

1. A method of designing an airbag used as a vehicle safety device for increasing occupant safety in an automobile collision, said method comprising:
receiving a three-dimensional (3-D) computerized model representing an airbag in a fully-inflated configuration, said 3-D computerized model containing a plurality of shell finite elements, wherein each of the shell finite elements is designated to one of a plurality of fabric panels that form the airbag;
creating a two-dimensional (2-D) mesh model using those shell finite elements being designated to said each of the fabric panels by unfolding each of said those shell finite elements from a first orientation in the fully-inflated configuration to a second orientation in a flat geometry of the 2-D mesh model;
adjusting the 2-D mesh model such that total area of the 2-D mesh model is within a tolerance when comparing with total surface area of said those shell elements being designated to said each of the fabric panels; and
orientating the 2-D mesh model with a fabric material coordinate system of warp and weft that is suitable for determining manufacturability.

2. The method of claim 1, further comprises retaining an element identifier of said each of said those shell elements of the 3-D computerized model in the 2-D mesh model.

3. The method of claim 4, wherein said each of said those shell elements is defined by a first set of node in the 3-D computerized model and a second set of node numbers in the 2-D mesh model.

4. The method of claim 4, wherein the first orientation is defined in the first set of node numbers, while the second orientation is defined in the second set of node numbers.

5. The method of claim 1, wherein the shell finite elements comprise quadrilateral elements.

6. The method of claim 5, wherein the shell finite elements further comprise triangular elements.

7. The method of claim 1, further comprises removing area occupied by airbag vents from the 2-D mesh model.

8. A system for designing an airbag used as a vehicle safety device for increasing occupant safety in an automobile collision, said system comprising:
a main memory for storing computer readable code for an application module;
at least one processor coupled to the main memory, said at least one processor executing the computer readable code in the main memory to cause the application module to perform operations by a method of:
receiving a three-dimensional (3-D) computerized model representing an airbag in a fully-inflated configuration, said 3-D computerized model containing a plurality of shell finite elements, wherein each of the shell finite elements is designated to one of a plurality of fabric panels that form the airbag;
creating a two-dimensional (2-D) mesh model using those shell finite elements being designated to said each of the fabric panels by unfolding each of said those shell finite elements from a first orientation in the fully-inflated configuration to a second orientation in a flat geometry of the 2-D mesh model;
adjusting the 2-D mesh model such that total area of the 2-D mesh model is within a tolerance when comparing with total surface area of said those shell elements being designated to said each of the fabric panels; and orientating the 2-D mesh model with a fabric material coordinate system of warp and weft that is suitable for determining manufacturability.

9. The system of claim 8, further comprises retaining an element identifier of said each of said those shell elements of the 3-D computerized model in the 2-D mesh model.

10. The system of claim 9, wherein said each of said those shell elements is defined by a first set of node numbers in the 3-D computerized model and a second set of node numbers in the 2-D mesh model.

11. The system of claim 8, further comprises removing area occupied by airbag vents from the 2-D mesh model.

12. A computer readable storage medium containing instructions, when executed in a computer system, for designing an airbag used as a vehicle safety device for increasing occupant safety in an automobile collision by a method comprising:
receiving a three-dimensional (3-D) computerized model representing an airbag in a fully-inflated configuration, said 3-D computerized model containing a plurality of shell finite elements, wherein each of the shell finite elements is designated to one of a plurality of fabric panels that form the airbag;
creating a two-dimensional (2-D) mesh model using those shell finite elements being designated to said each of the fabric panels by unfolding each of said those shell finite elements from a first orientation in the fully-inflated configuration to a second orientation in a flat geometry of the 2-D mesh model;
adjusting the 2-D mesh model such that total area of the 2-D mesh model is within a tolerance when comparing with total surface area of said those shell elements being designated to said each of the fabric panels; and
orientating the 2-D mesh model with a fabric material coordinate system of warp and weft that is suitable for determining manufacturability.
